# EUROPÄISCHE PATENTSCHRIFT

(11) **EP 0 510 447 B1**
(45) Veröffentlichungstag und Bekanntmachung des Hinweises auf die Patenterteilung: **14.01.1998**
(21) Anmeldenummer: 92106143.8
(22) Anmeldetag: 09.04.1992
(51) Int. Cl.: G03F 7/038, G03F 7/004, G03F 7/039

(54) **Negativ arbeitendes strahlungsempfindliches Gemisch und damit hergestelltes strahlungsempfindliches Aufzeichnungsmaterial**
Negative-working radiation-sensitive composition and radiation-sensitive recording material produced therewith
Composition sensible aux rayonnements travaillant en négatif et matériau d'enregistrement sensible aux rayonnements produit de celle-ci

(30) Priorität: 20.04.1991 DE 4112972
(43) Veröffentlichungstag der Anmeldung: 28.10.1992
(73) Patentinhaber: Clariant GmbH, 65929 Frankfurt am Main (DE)
(72) Erfinder: Röschert, Horst, Dr., W-6531 Ober Hilbersheim (DE); Pawlowski, Georg, Dr., W-6200 Wiesbaden (DE); Fuchs, Jürgen, W-6093 Flörsheim/Wicker (DE)

## Beschreibung

Die Erfindung betrifft ein negativ arbeitendes strahlungsempfindliches Gemisch mit
a) einer Verbindung, die unter Einwirkung von aktinischer Strahlung eine starke Säure bildet,
b) einer Verbindung mit mindestens zwei durch Säure vernetzbaren Gruppen und
c) einem in Wasser unlöslichen, in wäßrig-alkalischen Lösungen löslichen oder zumindest quellbaren polymeren Bindemittel.

Die Erfindung betrifft weiterhin ein damit hergestelltes strahlungsempfindliches Aufzeichnungsmaterial, das zur Herstellung von Photoresists, elektronischen Bauteilen, Druckplatten oder zum Formteilätzen geeignet ist.

Die stetige Verkleinerung der Strukturen, beispielsweise in der Chip-Herstellung bis in den Bereich von weniger als 1 µm, erfordert veränderte lithographische Techniken. Um solche feinen Strukturen abzubilden, verwendet man Strahlung mit einer kurzen Wellenlänge, wie energiereiches UV-Licht, Elektronen- und Röntgenstrahlen. Das strahlungsempfindliche Gemisch muß an die kurzwellige Strahlung angepaßt sein. Eine Zusammenstellung der an das strahlungsempfindliche Gemisch gestellten Forderungen ist in dem Aufsatz von C.G. Willson "Organic Resist Materials - Theory and Chemistry" [Introduction to Microlithography, Theory, Materials, and Processing, Herausgeber L.F. Thompson, C.G. Willson, M.J. Bowden, ACS Symp. Ser., 219, 87 (1983), American Chemical Society, Washington] angegeben. Es bestand daher ein verstärkter Bedarf an strahlungsempfindlichen Gemischen, die in den neueren Technologien, wie der Mid- oder Deep-UV-Lithoqraphie, [Belichtung z. B. mit Excimer-Lasern bei Wellenlängen von 305 nm (XeF), 248 nm (KrF), 193 nm (ArF)], der Elektronen- oder der Röntgenstrahl-Lithographie, einsetzbar sind, vorzugsweise darüber hinaus in einem weiten Spektralbereich empfindlich sind und dementsprechend auch in der konventionellen UV-Lithographie verwendet werden können.

Negativ arbeitende strahlungsempfindliche Gemische, die Bisazide als Vernetzer und von Isopren abgeleitete Bindemittel enthalten, sind bekannt. Sie werden als strahlungsempfindliche Schichten bei der Herstellung von Druckplatten, gedruckten Schaltungen und integrierten Schaltkreisen verwendet. Ihr Einsatz in der Mikrolithographie ist jedoch durch verschiedene technische Nachteile begrenzt. So ist es schwierig, qualitativ hochwertige Schichten ohne Fehlstellen (pin-holes) herzustellen. Der Wärmestand solcher Mischungen ist unzureichend, d. h. die Resistbilder werden bei der Verarbeitung durch thermischen Fluß verzerrt. Schlieplich ist ihr Auflösungsvermögen auf Strukturen > 2 µm begrenzt, da sie bei der notwendigen Entwicklung mit organischen Lösemitteln auch in den gehärteten Bereichen unerwünscht hohe Quellung zeigen, was wiederum zu Strukturverzerrungen oder inhomogenen Entwicklungsprozessen und damit zu ungenauer Wiedergabe des durch die Belichtungsmaske vorgegebenen Bildes führt. Um Resistbilder mit einer Auflösung von besser als 2 µm herstellen zu können, sind andere negativ arbeitende strahlungsempfindliche Gemische entwickelt worden, die empfindlich gegenüber Strahlung kürzerer Wellenlänge sind, beispielsweise gegenüber energiereicher UV-, Elektronen oder Röntgenstrahlung. Ein derartiges Gemisch enthält beispielsweise ein Copolymer aus (2,3-Epoxy-propyl)-methacrylat und (2,3-Dichlor-propyl)methacrylat (DCOPA) oder eine Kombination der entsprechenden Homopolymeren. Die Glasübergangstemperatur dieses Gemisches ist jedoch für viele Anwendungen zu niedrig, insbesondere ist aber die geringe Plasmaätzbeständigkeit des Gemisches zu bemängeln. Darüber hinaus muß auch dieses Resistmaterial mit Entwicklern auf der Basis von wenig umweltfreundlichen, organischen Lösemitteln verarbeitet werden. Eine geringe Plasmaätzbeständigkeit zeigen auch andere bisher bekannte negativ arbeitende Photoresists auf aliphatischer Basis.

In der EP-A 0 164 248 ist ein säurehärtbares Gemisch beschrieben, das wäßrig-alkalisch entwickelbar ist, durch die Verwendung von Aromaten eine verbesserte Plasmaätzresistenz aufweist und gegenüber nahem UV-Licht (350 bis 450 nm) empfindlich ist. Als Säurebildner sind dabei insbesondere Sulfonsäureesterderivate des Diazonaphthochinons genannt worden, die bei der Belichtung schwach saure Carbonsäuren bilden und daher nur in vergleichsweise hoher Konzentration wirksam sind. Solche Gemische haben aber infolge der schwachen Absorption und des unzureichenden Ausbleichverhaltens des photolytischen Säurebildners eine geringe Empfindlichkeit für DUV-, Elektronen- und Röntgenstrahlung.

In der US-A 3 692 560 wird ein säurehärtbares Gemisch beschrieben, das ein säurevernetzbares Melaminderivat, einen Novolak und chlorierte Benzophenone als photolytische Säurebildner enthält. Auch diese Gemische haben im tiefen UV-Bereich keine ausreichende Empfindlichkeit.

Darüber hinaus sind Halogenwasserstoffsäuren als Vernetzungskatalysatoren unerwünscht, da diese bei den nachfolgenden Dotierungsprozessen mit den Dotierungsmitteln Reaktionen eingehen können. Des weiteren wirken im gehärteten Resist verbleibende Halogenwasserstoffsäuren stark korrosiv und können zur Zerstörung des zu bebildernden Materials und der Produktionsgeräte führen.

Das gleiche trifft für die in der EP 0 232 972 erwähnten säurebildenden Derivate des DDT's zu, die hochtoxisch sind und schon von daher nicht praxisgerecht sein können. Immerhin zeigen solche Verbindungen eine beachtliche Empfindlichkeit im tiefen UV-Bereich (200 bis 300 nm).

Als Verbindungen, die bei Bestrahlung eine starke Säure bilden, wurden bisher insbesondere Onium-Salze, wie Diazonium-, Phosphonium-, Sulfonium- und Jodonium-Salze von nicht nucleophilen Säuren, wie HSbF₆, HAsF₆, oder HPF₆ [J.V. Crivello, Polym. Eng. Sci., 23 (1983) 953] verwendet. Daneben sind Halogenverbindungen, insbesondere Trichlormethyltriazin-Derivate oder Trichlormethyloxadiazol-Derivate, o-Chinondiazidsulfonylchloride, o-Chinondiazid-4-sulfonsäureester, Organometall-Organohalogen-Kombinationen, Bis(sulfonyl)diazomethane, Sulfonyl-carbonyl-diazomethane (DE-A 39 30 087) oder Nitrobenzyltosylate [F.M. Houlihan et al., SPIE Proc., Adv. in Resist Techn. and Proc. 920 (1988) 67] empfohlen worden.

Diese Verbindungen werden in negativ oder positiv arbeitenden strahlungsempfindlichen Gemischen verwendet. Die Verwendung derartiger photolytischer Säurebildner bringt aber gewisse Nachteile mit sich, die ihre Einsatzmöglichkeiten in verschiedenen Anwendungsbereichen drastisch einschränken. So sind z.B. viele der Oniumsalze toxisch. Ihre Löslichkeit ist in vielen Lösemitteln unzureichend, weshalb nur wenige Lösemittel zur Herstellung einer Beschichtungslösung geeignet sind. Darüber hinaus werden bei Verwendung der Oniumsalze z.T. unerwünschte Fremdatome eingeführt, die insbesondere in der Mikrolithographie zu Prozeßstörungen führen können. Ferner bilden die Oniumsalze bei der Photolyse sehr stark korrodierend wirkende Brönstedt-Säuren. Diese Säuren greifen empfindliche Substrate an, so daß der Einsatz solcher Gemische zu unbefriedigenden Ergebnissen führt. Wie bereits früher erwähnt, bilden auch die Halogenverbindungen sowie die Chinondiazidsulfonsäurechloride stark korrosiv wirkende Halogenwasserstoffsäuren. Ferner besitzen derartige Verbindungen auf bestimmten Substraten nur eine begrenzte Haltbarkeit, die durch das Einfügen einer Zwischenschicht zwischen Substrat und strahlungsempfindlicher, photolytische Säurebildner enthaltender Schicht verbessert wurde. Diese Maßnahme führte jedoch zu einer unerwünschten Zunahme von Defekten und zu einer verminderten Reproduzierbarkeit (DE-A 36 21 376 = US-A 4 840 867).

In neueren Arbeiten von F.M. Houlihan et al., SPIE 920, 67 (1988) wurde anhand positiv arbeitender Systeme gezeigt, daß neben den oben genannten Säurebildnern auch Nitrobenzyltosylate, die bei Belichtung Sulfonsäuren mit geringer Wanderungstendenz bilden, in bestimmten säurelabilen Resistformulierungen verwendbar sind. Es kann aus diesen Ergebnissen abgeleitet werden, daß solche Verbindungen auch für photohärtbare Systeme verwendet werden können. Die dabei erzielten Empfindlichkeiten und die thermische Stabilität der Photoresists erwiesen sich jedoch als unzureichend. Trotz der bisher geleisteten intensiven Forschungstätigkeit auf diesem Gebiet ist derzeit kein strahlungsempfindliches Gemisch bekannt, mit dem sich ein negativ arbeitendes strahlungsempfindliches Aufzeichnungsmaterial herstellen läßt, das eine hohe Empfindlichkeit im DUV-Bereich (200 bis 300 nm) sowie eine hohe Auflösung besitzt, bei der Bestrahlung keine korrodierend wirkende Säure freisetzt und wäßrigalkalisch entwickelbar ist.

Es bestand daher ein Bedarf an strahlungsempfindlichen Gemischen mit photolytisch wirkenden Säurebildnern, die die oben beschriebenen Nachteile nicht aufweisen und somit eine ausreichende Reaktivität und Säurestärke besitzen, um Verbindungen des Typs (b) auch bei kurzen Belichtungszeiten zur Vernetzung zu bringen.

Aufgabe der Erfindung war es daher, ein strahlungsempfindliches Gemisch zu entwickeln, das neben säurebildenden auch säurevernetzbare Verbindungen enthält, wobei die säurebildenden Verbindungen möglichst stabil auf allen gebräuchlichen Substraten sein sollen und die daraus bei Bestrahlung gebildete Säure nicht korrosiv sein soll.

Gelöst wird die Aufgabe durch ein negativ arbeitendes strahlungsempfindliches Gemisch mit
a) einer Verbindung, die unter Einwirkung von aktinischer Strahlung eine starke Säure bildet,
b) einer Verbindung mit mindestens zwei durch Säure vernetzbaren Gruppen und
c) einem in Wasser unlöslichen, in wäßrig-alkalischen Lösungen löslichen oder zumindest quellbaren polymeren Bindemittel,
das dadurch gekennzeichnet ist, daß die Verbindung a) ein mit zwei oder drei (Hetero)arylsulfonsäuren verestertes 2,4,6-Tris-(2-hydroxy-ethoxy)-[1,3,5]triazin ist.

Die Arylsulfonsäuren weisen vorzugsweise 6 bis 10 aromatische Kohlenstoffatome auf. Beispiele hierfür sind die Benzolsulfonsäuren und die Naphthalinsulfonsäuren.

Die Heteroarylsulfonsäuren weisen neben 4 bis 9 Kohlenstoffatomen noch ein aromatisches Sauerstoff- oder Schwefelatom oder 1 oder 2 aromatische Stickstoffatome auf. Beispiele hierfür sind die Furan- und Thiophensulfonsäuren, die Pyrrol-, Pyridin-, Pyrimidin- und Pyrazin-sulfonsäuren. Auch Sulfonsäuren mit einem zweikernigen Heteroarylrest sind geeignet. Hierfür seien die Benzofuran-, Isobenzofuran-, Benzo[b]thiophen- und Indolsulfonsäuren genannt. Stickstoffhaltige Heterocyclen dürfen jedoch nicht basisch sein.

Die Aryl- wie auch die Heteroarylsulfonsäuren können substituiert sein. Im Prinzip können alle Substituenten, die keine unerwünschten Reaktionen eingehen, vorkommen. Geeignete Substituenten sind lineare und verzweigte Alkylgruppen mit vorzugsweise nicht mehr als 8 Kohlenstoffatomen, wie Methyl, Ethyl, Propyl, Isopropyl, Butyl, sec.-Butyl, Isobutyl und tert.-Butyl. Die Alkylgruppen können fluoriert, bevorzugt auch perfluoriert, sein. Von den perfluorierten Alkylresten sind Trifluormethyl und Perfluorbutyl geeignet. Weitere geeignete Substituenten sind (C₁-C₈)Alkoxy, (C₁-C₈) Alkoxy-(C₁-C₈)alkoxy, (C₁-C₈)Alkanoyl, (C₁-C₈)Alkanoyloxy, (C₁-C₈)Alkanoylamino, (C₆-C₁₀)Aryl, (C₆-C₁₀)Aryloxy, (C₆-C₁₀)Aryl-(C₁-C₈)alkoxy, (C₆-C₁₁)Aroylamino, (C₆-C₁₁)Aroylamino-(C₁-C₈)alkyl, Cyano und Halogen. Die Substituenten können mehrfach auftreten. Unabhängig davon können verschiedene Substituenten nebeneinander vorhanden sein. Bevorzugte Substituenten sind (C₁-C₄)Alkyl, (C₁-C₄)Alkoxy und Halogen.

Ein Sulfonsäureester aus 3 mol (Hetero)arylsulfonsäure und 1 mol 2,4,6-Tris-(2-hydroxy-ethoxy-[1,3,5]triazin ist im allgemeinen bevorzugt gegenüber einem Sulfonsäureester aus 2 mol (Hetero)arylsulfonsäure und 1 mol 2,4,6-Tris-(2-hydroxy-ethoxy-[1,3,5]triazin. Ein solches, niedriger verestertes Produkt kann jedoch in speziellen Fällen eine bessere Löslichkeit aufweisen.

Besonders geeignete (Hetero)arylsulfonsäuren sind Benzol-, 3-Perfluoroctyl-benzol-, 4-Trifluormethyl-benzol-, 4-Perfluorbutyl-benzol-, Toluol-4-, 4-Bromo-benzol-, 4-Cyano-benzol-, 4-tert.-Butyl-benzol-, 2,4,5-Trimethylbenzol-, 3,4-Dichlor-benzolsulfonsäure und 5-Benzoylaminomethyl-thiophen-2-sulfonsäure.

Die mit den Sulfonsäuren gebildeten Ester sind besonders geeignet, weil sie mit einer hohen Quantenausbeute photolysiert werden können, gleichzeitig aber auch eine ausreichende thermische Stabilität besitzen. Die bei der Photolyse gebildete Säure ist stark genug, um die Vernetzung der im erfindungsgemäßen Gemisch enthaltenen vernetzbaren Komponenten b) zu bewirken.

Die Herstellung der in dem erfindungsgemäßen Gemisch eingesetzten, mehrfunktionellen Sulfonsäureester ist an sich bekannt. Als Ausgangsmaterialien dienen dabei in erster Linie die entsprechenden Sulfonsäurechloride. Verfahren zu Herstellung von aromatischen Sulfonsäureestern werden beispielsweise von F. Muth in: Houben-Weyl-Müller, Methoden der organischen Chemie, Bd. IX, S. 633 (und dort zitierte Literatur), Thieme-Verlag, 4. Aufl., Stuttgart 1955, und von S. Pawlenko, a.a.O., Bd. E 11, S. 1084, Thieme-Verlag, 1. Aufl., Stuttgart 1985, sowie in der Patentliteratur an zahlreichen Beispielen beschrieben. Auch die entsprechenden Sulfonsäureanhydride sind als Ausgangsmaterialien geeignet (siehe S. Pawlenko, a.a.O., Bd. E11, S. 1086, Thieme-Verlag, 1. Aufl., Stuttgart 1985, und P. J. Stang, M. Hanack, L. R. Subramaniam, Synthesis, **1982**, 85). Dies gilt insbesondere für die mit Perfluoralkyl-Gruppen substituierten Benzolsulfonsäureanhydride.

Das erfindungsgemäße, strahlungsempfindliche Gemisch zeichnet sich durch eine hohe Empfindlichkeit über einen weiten Spektralbereich aus. Es zeigt eine hohe thermische Stabilität und schafft die Möglichkeit, auch feinste Strukturen einer Vorlage detailgenau wiederzugeben. Die bei der Bestrahlung gebildete Säure wirkt nicht korrodierend, so daß das Gemisch auch auf empfindlichen Substratmaterialien Verwendung finden kann.

Überraschenderweise zeigen die erfindungsgemäßen, negativ arbeitenden, strahlungsempfindlichen Gemische nicht nur eine hohe thermische und Plasmaätzbeständigkeit sondern auch hervorragende lithographische Eigenschaften, die eine Auflösung im Halbmikrometer- und teilweise auch im Sub-Halbmikrometer-Bereich erlauben.

Man erhält nach dem bildmäßigen Bestrahlen und anschließendem Entwickeln ein detailgetreues Abbild der Maske. Die Resistfelder weisen steile Flanken auf. In den nichtbestrahlten Bereichen wird die Resistschicht vollständig abgelöst, d. h. es bleiben keinerlei Reste oder Rückstände der Schicht auf dem Substrat. Die bei der Photolyse gebildeten Sulfonsäuren führen zu einer effizienten Vernetzung der Resist-Komponenten b) und c), was die Herstellung von hochempfindlichen, negativ arbeitenden Gemischen erlaubt.

Mit den erfindungsgemäßen Gemischen hergestellte Aufzeichnungsmaterialien zeigen überraschend eine höchsten Ansprüchen genügende Bilddifferenzierung und, noch überraschender, eine Verbesserung des Kontrasts und des Auflösungsvermögens. Die erfindungsgemäßen Gemische erlauben beispielsweise die Herstellung eines hochempfindlichen negativ arbeitenden Photoresists für energiereiche UV2-Strahlung (z. B. 248 nm).

Da das erfindungsgemäße Gemisch über einen weiten Spektralbereich empfindlich ist, ist zum bildmäßigen Bestrahlen aktinische Strahlung allgemein geeignet. Als aktinische Strahlung soll in diesem Zusammenhang jede Strahlung verstanden werden, deren Energie mindestens der des kurzwelligen sichtbaren Lichts entspricht. Geeignet ist dabei insbesondere UV-Strahlung im Bereich von 190 bis 450 nm, bevorzugt von 200 bis 400 nm, besonders bevorzugt von 200 bis 300 nm, aber auch Elektronen- oder Röntgenstrahlung.

Die im erfindungsgemäßen, strahlungsempfindlichen Gemisch enthaltenen, bei Bestrahlung Säure bildenden mehrfunktionellen Sulfonsäureester können allein oder in Kombination mit anderen Säurebildnern Verwendung finden. Als zusätzliche Säurebildner sind insbesondere die in der gleichzeitig eingereichten deutschen Patentanmeldung P 41 12 974.1 beschriebenen mehrfunktionellen Sulfonsäureester aromatischer Polyhydroxy-Verbindungen geeignet.

Darüber hinaus lassen sich die mehrfunktionellen Sulfonsäureester auch mit Onium-Salzen, Halogenverbindungen, insbesondere Trichlormethyltriazinderivaten oder Trichlormethyloxadiazolderivaten, 1,2-Disulfonen, o-Chinondiazidsulfonylchloriden oder Organometall-Organohalogen-Kombinationen kombinieren. Es kommen aber auch Mischungen mit Bis(sulfonyl)diazomethanen und Sulfonylcarbonyldiazomethanen in Frage. In solchen Gemischen können jedoch die eingangs erwähnten Nachteile wieder auftreten.

Der Anteil an mehrfunktionellen Sulfonsäureestern im erfindungsgemäßen Gemisch liegt im allgemeinen bei 0,5 bis 25 Gew.-%, bevorzugt bei 3 bis 15 Gew.-%, bezogen auf das Gesamtgewicht der Feststoffe im Gemisch.

Als säurevernetzbare Verbindungen b) kommen besonders die in der GB 2,082,339 offenbarten Resole, daneben auch mit Alkoxymethyl- oder Oxiranylmethyl-Gruppen substituierte Aromaten (EP-A 0 212 482) sowie monomere und oligomere Melamin- bzw. Harnstoff-Formaldehyd-Kondensate (EP-A 0 133 216, DE-A 36 34 371, DE 37 11 264) in Betracht. Beispiele für den ersten Typ sind insbesondere die kommerziell erhältlichen Resolprodukte Bakelite R 5363, Bakelite R 17620, Bakelite R 10282 und Kelrez 40-152 (Bakelite und Kelrez sind eingetragene Warenzeichen). Resolderivate sind jedoch insgesamt nicht bevorzugt, da sie im tiefen UV-Bereich verhältnismäßig hohe Absorptionen aufweisen und damit zu einer Beeinträchtigung der Bildwiedergabe führen.

Besser geeignet sind die aus der EP-A 0 212 482 bekannten Vernetzer der allgemeinen Formel I

(R¹O-CHR³)ₙ-A-(CHR³-OR²)ₘ (**I**)

in der
- A: -B- oder -B-Y-B- ist und
- B: einen ggf. substituierten einkernigen aromatischen Kohlenwasserstoff oder eine Sauerstoff oder Schwefel enthaltende heterocyclische aromatische Verbindung darstellt,
- Y: eine Einfachbindung, (C₁-C₄)Alkylen oder (C₁-C₄)Alkylendioxy, deren Ketten durch Sauerstoffatome unterbrochen sein können, -O-, -S-, -SO₂-, -CO-, -CO₂-, -O-CO₂-, -CONH- oder -O-C₆H₄-O- bedeutet,
- R¹ und R²: Wasserstoff, (C₁-C₆)Alkyl, C₅ oder c₆-Cycloalkyl-, ggf. substituiertes (C₆-C₁₂)Aryl, (C₆-C₁₂)Aralkyl oder Acyl ist,
- R³: Wasserstoff, (C₁-C₄)Alkyl oder ggf. substituiertes Phenyl,
- n: eine ganze Zahl von 1 bis 3 und
- m: eine ganze Zahl von 0 bis 3, wobei n+m mindestens 2 ist, bedeuten.

Typische Vernetzer sind demnach Aromaten und Heterocyclen, die mehrfach mit Hydroxymethyl-, Acetoxymethyl- und Methoxymethyl-Gruppen substituiert sind.

Weitere bevorzugte Vernetzer sind Melamin/Formaldehyd-Derivate, die beispielsweise mindestens zwei freie N-Hydroxymethyl-, N-Alkoxamethyl- oder N-Acyloxymethylgruppen aufweisen. Insbesondere die N-Alkoxymethylderivate sind zum Einsatz in dem erfindungsgemäßen strahlungsempfindlichen Gemisch geeignet.

Die Vernetzer sind in Lage, bei erhöhten Temperaturen unter dem Einfluß der photolytisch erzeugten Säure mit den polymeren Bindemitteln zu vernetzen. Allgemein sind sie dadurch gekennzeichnet, daß sie unter den genannten Temperatur- und Säurebedingungen ein Carbonium-ion bilden können.

Der Gehalt an säurevernetzbarem Material b) in dem erfindungsgemäßen strahlungsempfindlichen Gemisch liegt zweckmäßig bei 1 bis 50 Gew.-%, vorzugsweise bei 5 bis 25 Gew.-%, jeweils bezogen auf das Gesamtgewicht der festen Bestandteile des Gemisches.

Das erfindungsgemäße strahlungsempfindliche Gemisch enthält ferner mindestens ein polymeres, in Wasser unlösliches, in wäßrig-alkalischen Lösungen aber lösliches, zumindest aber quellbares Bindemittel c). Das Bindemittel zeichnet sich im besonderen dadurch aus, daß es die übrigen Bestandteile des erfindungsgemäßen strahlungsempfindlichen Gemisches gut löst und insbesondere im Wellenlängenbereich von 190 bis 300 nm eine möglichst geringe Eigenabsorption, d.h. eine hohe Transparenz, aufweist. Bindemittel auf der Basis von Novolak-Kondensationsharzen, die in der Regel in Kombination mit Naphthochinondiaziden als photoaktive Komponenten eingesetzt werden, erfüllen diese Bedingung nicht. Zwar lassen Novolak-Kondensationsharze nach bildmäßiger Belichtung in den nicht belichteten Bereichen eine Erniedrigung der Löslichkeit gegenüber wäßrig-alkalischen Entwicklern erkennen, doch ist ihre Eigenabsorption im Bereich der für die Bestrahlung gewünschten kurzen Wellenlänge unerwünscht hoch.

Novolak-Kondensationsharze können aber in Mischung mit anderen als Bindemittel geeigneten Harzen mit höherer Transparenz eingesetzt werden. Die Mischungsverhältnisse richten sich dabei vorwiegend nach der Art des mit dem Novolakharz zu mischenden Bindemittels. Insbesondere spielen dessen Grad an Eigenabsorption im genannten Wellenlängenbereich, aber auch die Mischbarkeit mit den anderen Bestandteilen des strahlungsempfindlichen Gemisches eine entscheidende Rolle. Im allgemeinen kann aber das Bindemittel des erfindungsgemäßen strahlungsempfindlichen Gemisches bis zu 30 Gew.-%, insbesondere bis zu 20 Gew.-%, eines Novolak-Kondensationsharzes enthalten.

Als Bindemittel geeignet sind Homo- oder Copolymere des p-Hydroxystyrols sowie seiner Alkylderivate, z.B. des 3-Methyl-4-hydroxystyrols, sowie Homo- oder Copolymere anderer Vinylphenole, z. B. des 3-Hydroxystyrols oder der Ester oder Amide von Acrylsäure mit phenolischen Gruppen aufweisenden Aromaten. Als Comonomere können polymerisierbare Verbindungen wie Styrol, (Meth)acrylsäuremethacrylat oder ähnliche eingesetzt werden.

Gemische mit erhöhter Plasmabeständigkeit werden erhalten, wenn zur Herstellung der Bindemittel Silizium enthaltende Vinylmonomere, z. B. Vinyltrimethylsilan, mitverwendet werden. Die Transparenz dieser Bindemittel ist im interessierenden Bereich im allgemeinen höher, so daß eine verbesserte Strukturierung möglich ist.

Mit gleichem Erfolg lassen sich auch Homo- oder Copolymere des Maleinimids verwenden. Auch diese Bindemittel zeigen hohe Transparenz im beschriebenen Wellenlängenbereich. Als Comonomere werden auch hier bevorzugt Styrol, substituierte Styrole, Vinylether, Vinylester, Vinylsilylverbindungen oder (Meth)acrylsäureester eingesetzt.

Schließlich sind darüber hinaus auch Copolymere des Styrols mit Comonomeren verwendbar, die in wäßrig alkalischen Lösungen eine Löslichkeitserhöhung bewirken. Hierzu zählen beispielsweise Maleinsäureanhydrid und Maleinsäurehalbester.

Die genannten Bindemittel können auch untereinander gemischt werden, sofern sie die optischen Qualitäten des strahlungsempfindlichen Gemisches nicht verschlechtern. Bindemittelgemische sind jedoch nicht bevorzugt.

Die Menge des Bindemittels beträgt im allgemeinen 40 bis 95 Gew.-%, insbesondere 50 bis 90 Gew.-%, bezogen auf das Gesamtgewicht der festen Anteile des strahlungsempfindlichen Gemisches.

Ferner können den erfindungsgemäßen strahlungsempfindlichen Gemischen gegebenenfalls Farbstoffe, Pigmente, Weichmacher, Netzmittel und Verlaufmittel, aber auch Polyglykole, Celluloseether, z. B. Ethylcellulose, zur Erfüllung spezieller Erfordernisse, wie Flexibilität, Haftung und Glanz, zugesetzt werden.

Soll ein Substrat beschichtet werden, so wird das erfindungsgemäße strahlungsempfindliche Gemisch zweckmäßig in einem Lösemittel oder in einer Kombination von Lösemitteln gelöst. Hierfür besonders geeignet sind Ethylenglykol und Propylenglykol sowie die davon abgeleiteten Mono- und Dialkylether, besonders die Mono- und Dimethylether sowie die Mono- und Diethylether, Ester abgeleitet aus aliphatischen (C₁-C₆)Carbonsäuren und entweder (C₁-C₈)Alkanolen oder (C₁-C₈)Alkandiolen oder (C₁-C₆)Alkoxy-(C₁-C₈)alkanolen, beispielsweise Ethylacetat, Hydroxyethylacetat, Alkoxyethylacetat, n-Butylacetat, Propylenglykolmonoalkyletheracetat, insbesondere Propylenglykolmethyletheracetat und Amylacetat, Ether, wie Tetrahydrofuran und Dioxan, Ketone, wie Methylethylketon, Methylisobutylketon, Cyclopentanon und Cyclohexanon, N,N-Dialkyl-carbonsäureamide, wie N,N-Dimethylformamid und N,N-Dimethylacetamid, aber auch Hexamethylphosphorsäuretriamid, N-Methyl-pyrrolidin-2-on und Butyrolacton, sowie beliebige Mischungen davon. Besonders bevorzugt von diesen sind die Glykolether, aliphatischen Ester und Ketone.

Letztendlich hängt die Wahl des Lösemittels bzw. Lösemittelgemisches ab von dem angewandten Beschichtungsverfahren, der gewünschten Schichtstärke und den Trocknungsbedingungen. Ebenso müssen die Lösemittel unter den angewendeten Bedingungen gegenüber den übrigen Schichtbestandteilen chemisch inert sein.

Die mit den genannten Lösemitteln hergestellte Lösung hat in der Regel einen Feststoffgehalt von 5 bis 60 Gew.-%, vorzugsweise bis 50 Gew.-%.

Gegenstand der Erfindung ist schließlich auch ein strahlungsempfindliches Aufzeichnungsmaterial, das im wesentlichen aus einem Substrat und einem darauf aufgetragenen, strahlungsempfindlichen Gemisch besteht.

Als Substrate kommen alle Materialien in Frage, aus denen Kondensatoren, Halbleiter, mehrlagige gedruckte Schaltungen oder integrierte Schaltkreise bestehen bzw. hergestellt werden können. Speziell sind Siliciumsubstrate zu nennen, die auch thermisch oxidiert und/oder mit Aluminium beschichtet, aber auch dotiert sein können. Daneben sind alle anderen in der Halbleitertechnologie üblichen Substrate möglich, wie Siliciumnitrid, Galliumarsenid und Indiumphosphid. Weiterhin kommen die aus der Flüssigkristalldisplay-Herstellung bekannten Substrate in Frage, wie z. B. Glas und Indium-Zinnoxid, ferner Metallplatten und -folien - beispielsweise aus Aluminium, Kupfer, Zink-, Bimetall- und Trimetallfolien, aber auch elektrisch nichtleitende Folien, die mit Metallen bedampft sind, und Papier. Diese Substrate können thermisch vorbehandelt, oberflächlich aufgerauht, angeätzt oder, zur Verbesserung erwünschter Eigenschaften, z. B. zur Erhöhung der Hydrophilie, mit Chemikalien vorbehandelt sein.

Um der strahlungsempfindlichen Schicht einen besseren Zusammenhalt und/oder eine bessere Haftung auf der Substratoberfläche zu verleihen, kann in ihr ein Haftvermittler enthalten sein. Bei Silicium- bzw. Siliciumdioxid-Substraten kommen hierfür Haftvermittler vom Aminosilan-Typ, wie z. B. 3-Aminopropyltriethoxysilan oder Hexamethyldisilazan, in Frage.

Geeignete Träger für die Herstellung von photomechanischen Aufzeichnungsschichten, wie Druckformen für den Hochdruck, Flachdruck, Siebdruck und Flexodruck sind besonders Aluminiumplatten, die gegebenenfalls vorher anodisch oxidiert, gekörnt und/oder silikatisiert werden, daneben Zink- und Stahlplatten, die gegebenenfalls verchromt werden, sowie Kunststoffolien und Papier.

Das erfindungsgemäße Aufzeichnungsmaterial wird mit aktinischer Strahlung bildmäßig belichtet. Als Strahlungsquellen eignen sich besonders Metallhalogenidlampen, Kohlebogenlampen, Xenonlampen und Quecksilberdampflampen. Ebenso kann eine Belichtung mit energiereicher Strahlung wie Laser-, Elektronen- oder Röntgenstrahlung erfolgen. Besonders bevorzugt sind jedoch Lampen, die Licht einer Wellenlänge von 190 bis 260 nm ausstrahlen können, d.h. insbesondere Xenon- und Quecksilberdampflampen. Darüber hinaus lassen sich auch Laserlichtquellen verwenden, z. B. Excimerlaser, insbesondere KrF- oder ArF-Laser, die bei 248 bzw. 193 nm emittieren. Die Strahlungsquellen müssen in den genannten Wellenlängenbereichen eine ausreichende Emission aufweisen.

Die Stärke der lichtempfindlichen Schicht hängt vom Verwendungszweck ab. Sie beträgt im allgemeinen zwischen 0,1 und 100 µm, bevorzugt zwischen 0,5 und 10 µm, besonders bevorzugt um 1,0 µm.

Gegenstand der Erfindung ist ferner ein Verfahren zur Herstellung eines strahlungsempfindlichen Aufzeichnungsmaterials. Das Auftragen des strahlungsempfindlichen Gemisches auf das Substrat kann durch Aufsprühen, Fließbeschichten, Walzen, Schleuder- und Tauchbeschichten erfolgen. Danach wird das Lösemittel durch Verdampfen entfernt, so daß auf der Oberfläche des Substrats die strahlungsempfindliche Schicht zurückbleibt. Die Entfernung des Lösemittels kann durch Erhitzen der Schicht auf Temperaturen bis zu 150 °C gefördert werden.

Das Gemisch kann aber auch zunächst auf obengenannte Weise auf einen Zwischenträger aufgetragen werden, von dem aus es unter Druck und erhöhter Temperatur auf das endgültige Trägermaterial übertragen wird. Als Zwischenträger können grundsätzlich alle auch als Trägermaterialien geeigneten Materialien Anwendung finden. Anschließend wird die Schicht bildmäßig bestrahlt. Danach behandelt man die Schicht mit einer Entwicklerlösung, die die nicht bestrahlten Bereiche der Schicht löst und entfernt, so daß ein Abbild der bei der bildmäßigen Bestrahlung verwendeten Vorlage auf der Substratoberfläche verbleibt.

Als Entwickler eignen sich besonders wäßrige Lösungen, die Silikate, Metasilikate, Hydroxide, Hydrogen- und Dihydrogenphosphate, Carbonate oder Hydrogencarbonate von Alkalimetall-, Erdalkalimetall- und/oder Ammoniumionen enthalten, aber auch Ammoniak und dergleichen. Metallionenfreie Entwickler werden in der US-A 4 729 941, der EP-A 0 062 733, der US-A 4 628 023, der US-A 4 141 733, der EP-A 0 097282 und der EP-A 0 023 758 beschrieben. Der Gehalt dieser Substanzen in der Entwicklerlösung beträgt im allgemeinen 0,1 bis 15 Gew.-%, vorzugweise 0,5 bis 5 Gew.-%, bezogen auf das Gewicht der Entwicklerlösung. Metallionenfreie Entwickler werden bevorzugt verwendet. Den Entwicklern können gegebenenfalls geringe Mengen eines Netzmittels zugesetzt sein, um die Ablösung der löslichen Bereiche der Schicht zu erleichtern.

Die entwickelten Schichtstrukturen können nachgehärtet werden. Dies geschieht im allgemeinen durch Erhitzen auf einer hot-plate bis zu einer Temperatur unterhalb der Fließtemperatur und anschliependes ganzflächiges Belichten mit dem UV-Licht einer Xenon-Quecksilber-Dampflampe (Bereich von 200 bis 250 nm). Durch die Nachhärtung werden die Bildstrukturen vernetzt, so daß sie im allgemeinen eine Fließbeständigkeit bis zu Temperaturen von über 200 °C aufweisen. Die Nachhärtung kann auch ohne Temperaturerhöhung allein durch Bestrahlen mit energiereichem UV-Licht erfolgen.

Verwendung finden die erfindungsgemäßen Verbindungen in strahlungsempfindlichen Gemischen zur Herstellung integrierter Schaltungen oder von diskreten elektrischen Bausteinen in lithographischen Prozessen, da sie eine hohe Lichtempfindlichkeit aufweisen, besonders bei Bestrahlung mit Licht einer Wellenlänge zwischen 190 bis 300 nm. Da die Gemische bei Belichtung sehr gut ausbleichen, lassen sich Strukturierungen erzielen, die denen der bekannten Gemische hinsichtlich ihres Auflösungsvermögens deutlich überlegen sind. Das aus dem Gemisch hergestellte Aufzeichnungsmaterial dient dabei als Maske für die folgenden Prozeßschritte. Hierunter zählen z. B. das Ätzen des Schichtträgers, die Implantation von Ionen in den Schichtträger oder die Abscheidung von Metallen oder anderen Materialien auf den Schichtträger.

Die nachstehend beschriebenen Beispiele illustrieren die Erfindung, die aber nicht darauf beschränkt sein soll.

### Synthesebeispiel

### 2,4,6-Tris-[2-(toluol-4-sulfonyloxy)-ethoxy]-[1,3,5]triazin

Zu einer Lösung von 20,0 g (76,5 mmol) 2,4,6-Tris-(2-hydroxy-ethoxy)-[1,3,5]triazin und 60,6 g (760 mmol) Pyridin in 400 ml trockenem Acetonitril wurden bei 0 °C 73,8 g (380 mmol) p-Toluolsulfonsäurechlorid innerhalb von 10 min zugegeben und 4 h bei 0 °C gerührt. Anschließend wurde das Eisbad entfernt und auf Raumtemperatur erwärmen gelassen. Die Mischung wurde nun langsam und unter ständigem Rühren in 300 ml Eiswasser eingetropft und anschließend mit 400 ml Dichlormethan extrahiert. Die organische Phase wurde mehrmals mit gesättigter, wäßriger Natriumsulfatlösung gewaschen und mit Natriumsulfat getrocknet. Dann wurde das Lösemittel im Vakuum abdestilliert. Der Rückstand wurde in 500 ml Dichlormethan aufgenommen, dreimal mit je 150 ml 3 n wäßriger Salzsäure und zweimal je 150 ml gesättigter, wäßriger Natriumsulfatlösung gewaschen und anschließend mit Magnesiumsulfat getrocknet. Das Lösemittel wurde wiederum im Vakuum abdestilliert. Die letzten flüchtigen Bestandteile wurden im Hochvakuum entfernt, wobei der Rückstand unter Aufschäumen erstarrte. Es wurden 36,5 g (67 %) eines nahezu farblosen Pulvers erhalten.

Die Umkristallisation aus einem Lösemittelgemisch Isopropanol/Aceton ergab ein farbloses Pulver mit einem Schmelzpunkt von 111 °C.

Die Analyse dieser Verbindung ergab folgende Werte:

| | | | | |
|---|---|---|---|---|
| ber. | C 49,78 % | H 4,60 % | N 5,81 % | S 13,29 % |
| gef. | C 49,3 % | H 4,4 % | N 5,6 % | S 13,4 % |

Die Charakterisierung der Sulfonsäureester des 2,4,6-Tris-(2-hydroxy-ethoxy)-[1,3,5]triazins erfolgte durch ¹H- und ¹³C-Hochfeld-Kernresonanzspektren, durch Elementaranalysen sowie dünnschichtchromatographisch (zum Beweis der Abwesenheit von nicht umgesetztem Sulfonsäurechlorid) und ggf. IR-spektroskopisch (zum Beweis der Abwesenheit freier Hydroxygruppen im Produkt).

Die Anwendungsbeispiele 1 bis 8 belegen die Eignung des erfindungsgemäßen Gemisches für Aufzeichnungsmaterialien in der Mikrolithographie bei Verwendung unterschiedlicher Strahlungsquellen. Anhand der Vergleichsbeispiele 9 und 10 wird die Überlegenheit der erfindungsgemäßen Gemische gegenüber dem Stand der Technik nachgewiesen. Die Beispiele 11 und 12 dokumentieren die Anwendbarkeit des Gemisches in gedruckten Schaltungen und Flachdruckplatten.

### Anwendungsbeispiele

Die Beschichtungslösungen wurden durch Filter mit einem Porendurchmesser von 0,2 µm filtriert und auf einen mit einem Haftvermittler (Hexamethyldisilazan) vorbehandelten Wafer aufgeschleudert. Die Schleuderdrehzahl wurde dabei so gewählt, daß nach der Trocknung bei 105 °C für 1 min auf der hot plate Schichtdicken um 1,07 µm erhalten wurden.

Sofern bei den einzelnen Beispielen nichts anderes angegeben ist, wurde das Aufzeichnungsmaterial bildmäßig mit der UV-Strahlung eines KrF-Excimerlasers (248 nm) oder einer Xenon-Quecksilberdampflampe (260 nm, mit Interferenzfilter) belichtet und anschließend bei 110 °C für 1 min einem post exposure bake auf einer hot plate unterzogen.

Entwickelt wurde das Aufzeichnungsmaterial mit einer 0,27 n wäßrigen Tetramethylammoniumhydroxid-Lösung.

In den folgenden Beispielen wurden Gewichtsteile mit Gt abgekürzt.

### Beispiel 1

Es wurde ein lichtempfindliches Aufzeichnungsmaterial hergestellt mit Hilfe einer Beschichtungslösung, bestehend aus

| | |
|---|---|
| 7,5 Gt | eines Homopolymeren aus 3-Methyl-4-hydroxystyrol mit einem Erweichungsbereich von ≥ 150 °C und einem mittleren Molekulargewicht von 25.000 [bestimmt durch Gelpermeationschromatographie (GPC)], |
| 2,5 Gt | eines Kresol-Formaldehyd-Resols (Bakelite R5363) und |
| 0,8 Gt | 2,4,6-Tris-[2-(4-brom-benzolsulfonyloxy)-ethoxy]-[1,3,5]triazin (hergestellt analog dem Synthesebeispiel) in |
| 42 Gt | Propylenglykol-monomethylether-acetat. |

| | |
|---|---|
| Belichtung | 24 mJ/cm² (Xenon-Quecksilberdampflampe) |
| Entwicklung | 105 s |

### Beispiel 2

Es wurde ein lichtempfindliches Aufzeichnungsmaterial hergestellt mit Hilfe einer Beschichtungslösung, bestehend aus

| | |
|---|---|
| 8,0 Gt | eines Copolymeren aus 3-Methyl-4-hydroxystyrol/p-Hydroxystyrol (75/25) mit einem einem Erweichungsbereich von > 150 °C und einem mittleren Molekulargewicht um 28.000 (GPC), |
| 2,0 Gt | Hexa-N-methoxymethyl-melamin und |
| 1,0 Gt | 2,4,6-Tris-[2-(toluol-4-sulfonyloxy)-ethoxy][1,3,5]triazin (hergestellt gemäß Synthesebeispiel) in |
| 42 Gt | Propylenglykol-monomethylether-acetat. |

| | |
|---|---|
| Belichtung | 27 mJ/cm² (Xenon-Quecksilberdampflampe) |
| Entwicklung | 90 s |

### Beispiel 3

Es wurde ein lichtempfindliches Aufzeichnungsmaterial hergestellt mit Hilfe einer Beschichtungslösung, bestehend aus

| | |
|---|---|
| 7,5 Gt | eines 1:1 Copolymeren aus Styrol und Maleimid mit einem Erweichungsbereich von 165 bis 180 °C, |
| 2,0 Gt | Hexa-N-acetoxymethyl-melamin und |
| 0,7 Gt | 2,4,6-Tris-[2-(4-trifluormethyl-benzolsulfonyloxy)-ethoxy]-[1,3,5]triazin (hergestellt analog dem Synthesebeispiel) in |
| 42 Gt | Propylenglykol-monomethylether-acetat. |

| | |
|---|---|
| Belichtung | 38 mJ/cm² (Xenon-Quecksilberdampflampe) |
| Post exposure bake | 2 min, 115 °C, hot plate |
| Entwicklung | 80 s (0,02 n wäßrige Tetramethylammoniumhydroxid-Lösung) |

### Beispiel 4

Es wurde ein lichtempfindliches Aufzeichnungsmaterial hergestellt mit Hilfe einer Beschichtungslösung, bestehend aus

| | |
|---|---|
| 7,5 Gt | eines 1:1 Copolymeren aus Styrol und Maleimid mit einem Erweichungsbereich von 165 bis 180 °C, |
| 2,5 Gt | 4,4'-Bis-methoxymethyl-diphenylsulfon und |
| 0,8 Gt | 2,4,6-Tris-(2-benzolsulfonyloxy-ethoxy)[1,3,5]triazin (hergestellt gemäß Synthesebeispiel) in |
| 42 Gt | Propylenglykol-monomethylether-acetat. |

| | |
|---|---|
| Softbake | 1 min, 100 °C, hot plate |
| Belichtung | 43 mJ/cm² (Xenon-Quecksilberdampflampe) |
| Entwicklung | 75 s (0,02 n wäßrige Tetramethylammoniumhydroxid-Lösung) |

### Beispiel 5

Es wurde ein lichtempfindliches Aufzeichnungsmaterial hergestellt mit Hilfe einer Beschichtungslösung, bestehend aus

| | |
|---|---|
| 7,5 Gt | eines Copolymeren aus Styrol und Maleimid (Molverhältnis 50:50) mit einem Erweichungsbereich von 165 bis 180 °C, |
| 2,5 Gt | 4,4'-Bis-methoxymethyl-diphenylether und |
| 0,8 Gt | 2,4,6-Tris-2-(4-tert.-butyl)benzolsulfonyloxy)-ethoxy]-[1,3,5]triazin (hergestellt analog dem Synthesebeispiel) in |
| 42 Gt | Propylenglykol-monomethylether-acetat. |

| | |
|---|---|
| Belichtung | 44 mJ/cm² (Xenon-Quecksilberdampflampe) |
| Post exposure bake | 2 min, 115 °C, hot plate |
| Entwicklung | 60 s (0,02 n wäßrige Tetramethylammoniumhydroxid-Lösung) |

### Beispiel 6

Es wurde ein lichtempfindliches Aufzeichnungsmaterial hergestellt mit Hilfe einer Beschichtungslösung, bestehend aus

| | |
|---|---|
| 7,5 Gt | eines Copolymeren aus Styrol/4-Hydroxystyrol (20:80) mit einem mittleren Molekulargewicht um 32.000 (GPC), |
| 2,5 Gt | Hexa-N-butoxymethyl-melamin und |
| 0,8 Gt | 2,4,6-Tris-[2-(toluol-4-sulfonyloxy)-ethoxy][1,3,5]triazin (hergestellt analog dem Synthesebeispiel) in |
| 42 Gt | Propylenglykol-monomethylether-acetat. |

| | |
|---|---|
| Belichtung | 42 mJ/cm² (KrF-Excimerlaser) |
| Post exposure bake | 90 s, 110 °C, hot plate |
| Entwicklung | 60 s (0,02 n wäßrige Tetramethylammoniumhydroxid-Lösung) |

### Beispiel 7

Es wurde ein lichtempfindliches Aufzeichnungsmaterial hergestellt mit Hilfe einer Beschichtungslösung gemäß Beispiel 1, indem 2,5 Gt eines Kresol-Formaldehyd-Resols (Bakelite R5363) durch 2,0 Gt Hexa-N-methoxymethyl-melamin ersetzt wurden.

| | |
|---|---|
| Belichtung | 20 mJ/cm² (KrF-Excimerlaser) |
| Entwicklung | 90 s |

### Beispiel 8

Es wurde ein lichtempfindliches Aufzeichnungsmaterial hergestellt mit Hilfe einer Beschichtungslösung wie im Beispiel 2, jedoch mit der Abweichung, daß anstelle des dort verwendeten 2,4,6-Tris-[2-(toluol-4-sulfonyloxy)ethoxy]-[1,3,5]triazins eine gleiche Menge (0,8 Gt) an 2,4,6-Tris-[2-(3,4-dichlor-benzolsulfonyloxy)-ethoxy][1,3,5]triazin eingesetzt wurde.

| | |
|---|---|
| Belichtung | 31 mJ/cm² (KrF-Excimerlaser) |
| Entwicklung | 90 s |

### Bewertung der entwickelten Aufzeichnungsmaterialien

Die gemäß den Beispielen 1 bis 8 erhaltenen Resiststrukturen stellten ein fehlerfreies, negatives Abbild der Maske mit zufriedenstellend steilen Resistflanken dar, wobei Strukturen ≤ 0,50 µm detailgetreu wiedergegeben waren.

Eine rasterelektronenmikroskopische Untersuchung zeigte, daß die Resistflanken senkrecht zur Substratoberfläche ausgerichtet waren.

Die Schichtabträge in den belichteten Resistbereichen lagen nach Messungen mit einem Schichtdickenmeßgerät der Fa. Rudolph in allen Fällen bei < 20 nm/min, in vielen Fällen bei < 10 nm/min.

### Beispiele 9 und 10 (Vergleichsbeispiel)

Die Beschichtungslösung gemäß Beispiel 7 wurde derart abgewandelt, daß die dort verwendete säurebildende Verbindung durch die gleiche Menge an Triphenylsulfoniumhexafluorophosphat (Beispiel 9) oder 2-Nitrobenzyltosylat (Beispiel 10) ersetzt wurde. Nach einer Belichtung mit Strahlung einer Wellenlänge von 260 nm und einer Energie von 55 bzw. 115 mJ/cm² erhielt man Strukturen, die keine praxisgerechte Bilddifferenzierung zeigten.

Bei Verwendung des Onium-Salzes (Beispiel 9) wurden auch in den unbelichteten Bereichen Lackreste beobachtet, d. h. Resistreste hafteten in den unbelichteten Bereichen am Substrat an, während bei Verwendung des Tosylesters (Beispiel 10) unterschnittene Resistprofile sichtbar waren, die auch bei verstärkter Belichtung nur auf Kosten der Wiedergabegenauigkeit beseitigt werden konnten. Selbst unter Verwendung optimierter Bake- und Entwicklungsbedingungen konnten keine Resultate erzielt wurden, die zu akzeptablen Strukturierungen führten.

### Beispiel 11

Für die Herstellung einer Offsetdruckplatte wurde eine mechanisch aufgerauhte und vorbehandelte Aluminiumfolie mit einer Beschichtungslösung nachstehender Zusammensetzung schleuderbeschichtet:

| | |
|---|---|
| 7,5 Gt | eines Kresol-Formaldehyd-Novolaks mit einem Erweichungsbereich von 105 bis 120 °C, |
| 2,5 Gt | eines Kresol/Formaldehyd Resols (Bakelite R 5363), |
| 1,0 Gt | 2,4,6-Tris-[2-(4-brom-benzolsulfonyloxy)-ethoxy]-[1,3,5]triazin (hergestellt analog dem Synthesebeispiel) und |
| 0,05 Gt | Kristallviolettbase in |
| 90 Gt | Propylenglykol-monomethylether-acetat. |

Nach dem Trocknen der Schicht (Schichtgewicht ca. 2,5 g/m²) wurde unter einer negativen Testvorlage 55 s belichtet und die Platte nach 10 minütiger Lagerung für 2 min in einem Umluftofen mit einer Temperatur von 140 °C erwärmt. Es wurde mit einem Entwickler folgender Zusammensetzung entwickelt:

| | |
|---|---|
| 97,7 Gt | vollentsalztes Wasser, |
| 1,0 Gt | 2-n-Butoxy-ethanol, |
| 0,8 Gt | Natriummetasilikat x 9 H₂O und |
| 0,5 Gt | Natriumhydroxid. |

Bei der Entwicklung wurde eine detailgetreue negative Wiedergabe der Vorlage sichtbar. Nach Abspülen mit Wasser wurde die Platte durch Überwischen mit 1%iger Phosphorsäure druckfertig gemacht. Von dieser Druckplatte wurden 140.000 einwandfreie Drucke erhalten.

### Beispiel 12:

Die Lösung eines Ätz- und Galvanonegativtrockenresists wurde durch Bereitung nachstehender Zusammensetzung hergestellt:

| | |
|---|---|
| 12,5 Gt | des in Beispiel 11 beschriebenen Novolaks, |
| 10,0 Gt | Hexa-N-methoxymethyl-melamin, |
| 1,0 Gt | 2,4,6-Tris-[2-(3-perfluoroctyl-benzolsulfonyloxy)-ethoxy]-[1,3,5]triazin (hergestellt analog dem Synthesebeispiel) und |
| 0,1 Gt | Kristallviolett in |
| 30 Gt | Butanon. |

Eine für diesen Zweck übliche Polyethylenterephthalatfolie von 25 µm Dicke wurde mit dieser Lösung beschichtet, so dap sich eine Trockenschichtdicke von 18 µm ergab. Die Oberfläche des trockenen Resistfilms wurde mit einer weiteren Polyethylenterephthalatfolie kaschiert. Der Trockenfilm wurde nach Abziehen der Deckfolie unter Druck und Wärme auf ein Messingblech auflaminiert. Nach Abkühlen und Abziehen der Trägerfolie wurde das Blech durch eine Vorlage hindurch belichtet, wobei ein guter Bildkontrast sichtbar wurde. Das Material wurde 10 min gelagert und dann für 4 min auf 95 °C erwärmt. Die unbelichteten Stellen wurden mit einem Entwickler der in Beispiel 11 angegebenen Zusammensetzung sprühentwickelt. Das Blech wurde anschließend mit handelsüblicher Eisen(III)-chlorid-Lösung bis hin zu den glatten Flanken durchgeätzt. Es ist möglich, die erhaltenen Formteile vor dem Trennen noch weiter zu bearbeiten.

## Patentansprüche

1. Negativ arbeitendes strahlungsempfindliches Gemisch mit
a) einer Verbindung, die unter Einwirkung von aktinischer Strahlung eine starke Säure bildet,
b) einer Verbindung mit mindestens zwei durch Säure vernetzbaren Gruppen und
c) einem in Wasser unlöslichen, in wäßrigalkalischen Lösungen löslichen oder zumindest quellbaren polymeren Bindemittel,
dadurch gekennzeichnet, daß die Verbindung a) ein mit 2 oder 3 (Hetero)arylsulfonsäuren verestertes 2,4,6-Tris-(2-hydroxy-ethoxy)-[1,3,5]triazin ist.

2. Negativ arbeitendes strahlungsempfindliches Gemisch gemäß Anspruch 1, dadurch gekennzeichnet, daß die Arylsulfonsäuren 6 bis 10 aromatische Kohlenstoffatome aufweisen.

3. Negativ arbeitendes strahlungsempfindliches Gemisch gemäß Anspruch 1, dadurch gekennzeichnet, daß die Heteroarylsulfonsäuren 4 bis 9 Kohlenstoffatome und entweder 1 aromatisches Sauerstoff- oder Schwefelatom oder 1 oder 2 aromatische Stickstoffatome aufweisen.

4. Negativ arbeitendes strahlungsempfindliches Gemisch gemäß gemäß einem oder mehreren der Ansprüche 1 bis 3, dadurch gekennzeichnet, daß die (Hetero)arylsulfonsäuren mit (C₁-C₈)Alkyl, (C₁-C₈)Alkoxy, (C₁-C₈)Alkanoyl, (C₁-C₈)Alkanoyloxy, (C₁-C₈)Alkanoylamino, (C₆-C₁₀)Aroylamino, Cyano und/oder Halogen substituiert sind.

5. Negativ arbeitendes strahlungsempfindliches Gemisch gemäß gemäß einem oder mehreren der Ansprüche 1 bis 4, dadurch gekennzeichnet, daß die Verbindung a) unter Einfluß von Strahlung der Wellenlänge 190 bis 450 nm Säure bildet.

6. Negativ arbeitendes strahlungsempfindliches Gemisch gemäß gemäß einem oder mehreren der Ansprüche 1 bis 5, dadurch gekennzeichnet, daß das Bindemittel c) phenolische Hydroxygruppen enthält.

7. Negativ arbeitendes strahlungsempfindliches Gemisch gemäß Anspruch 6, dadurch gekennzeichnet, daß das Bindemittel ein gegebenenfalls substituiertes Poly(hydroxystyrol) ist.

8. Negativ arbeitendes strahlungsempfindliches Gemisch gemäß Anspruch 6, dadurch gekennzeichnet, daß das Bindemittel ein Polymer ist mit einer (Meth)acrylsäure, die mit einer Verbindung verestert ist, die neben der zur Esterbildung benötigten Hydroxygruppe freie, phenolische Hydroxygruppen aufweist.

9. Negativ arbeitendes strahlungsempfindliches Gemisch gemäß gemäß einem oder mehreren der Ansprüche 1 bis 8, dadurch gekennzeichnet, daß die vernetzbare Verbindung b) ein Resol ist.

10. Negativ arbeitendes strahlungsempfindliches Gemisch gemäß gemäß einem oder mehreren der Ansprüche 1 bis 8, dadurch gekennzeichnet, daß die vernetzbare Verbindung b) ein mit Alkoxymethyl- oder Oxiranylmethyl-Gruppen substituierter Aromat ist.

11. Negativ arbeitendes strahlungsempfindliches Gemisch gemäß gemäß einem oder mehreren der Ansprüche 1 bis 8, dadurch gekennzeichnet, daß die vernetzbare Verbindung b) ein Melamin/ Formaldehyd- oder Harnstoff/Formaldehyd-Kondensat ist.

12. Negativ arbeitendes strahlungsempfindliches Aufzeichnungsmaterial, das im wesentlichen aus einem Träger und einer strahlungsempfindlichen Schicht besteht, dadurch gekennzeichnet, daß die Schicht ein strahlungshärtbares Gemisch gemäß gemäß einem oder mehreren der Ansprüche 1 bis 11 enthält.

13. Negativ arbeitendes strahlungsempfindliches Aufzeichnungsmaterial gemäß Anspruch 12, dadurch gekennzeichnet, daß die unter Einwirkung aktinischer Strahlung eine starke Säure bildende Verbindung a) einen Anteil von 0,5 bis 25 Gew.-%, bevorzugt 1 bis 10 Gew.-%, besonders bevorzugt 2 bis 7 Gew.-%, am Gesamtgewicht der Feststoffe der strahlungsempfindlichen Schicht hat.

14. Negativ arbeitendes strahlungsempfindliches Aufzeichnungsmaterial gemäß Anspruch 12, dadurch gekennzeichnet, daß die Verbindung mit mindestens zwei durch Säure vernetzbaren Gruppen b) einen Anteil von 1 bis 50 Gew.-%, bevorzugt 5 bis 25 Gew.-%, am Gesamtgewicht der Feststoffe der strahlungsempfindlichen Schicht hat.

15. Negativ arbeitendes strahlungsempfindliches Aufzeichnungsmaterial gemäß Anspruch 12, dadurch gekennzeichnet, daß das in Wasser unlösliche, in wäßrigen Lösungen lösliche oder zumindest quellbare Bindemittel c) einen Anteil von 40 bis 95 Gew.-%, bevorzugt 50 bis 90 Gew.-%, am Gesamtgewicht der Feststoffe der strahlungsempfindlichen Schicht hat.

16. Negativ arbeitendes strahlungsempfindliches Aufzeichnungsmaterial gemäß Anspruch 12, dadurch gekennzeichnet, daß die strahlungsempfindliche Schicht bei einer Dicke von 1,0 µm für Strahlung der Wellenlänge 248 nm eine Extinktion von weniger als 0,5, bevorzugt von weniger als 0,3, aufweist.

## Claims

1. A negative-working radiation-sensitive mixture with
a) a compound which generates a strong acid under the action of actinic radiation,
b) a compound having at least two groups crosslinkable by means of acid and
c) a polymeric binder which is insoluble in water and soluble or at least swellable in aqueous alkaline solutions,
wherein the compound a) is a 2,4,6-tris-(2-hydroxyethoxy)-[1,3,5]triazine which is esterified with 2 or 3 (hetero)arylsulfonic acids.

2. A negative-working radiation-sensitive mixture as claimed in claim 1, wherein the arylsulfonic acids have 6 to 10 aromatic carbon atoms.

3. A negative-working radiation-sensitive mixture as claimed in claim 1, wherein the heteroarylsulfonic acids have 4 to 9 carbon atoms and either 1 aromatic oxygen or sulfur atom or 1 or 2 aromatic nitrogen atoms.

4. A negative-working radiation-sensitive mixture as claimed in one or more of claims 1 to 3, wherein the (hetero)arylsulfonic acids are substituted by (C₁-C₈)alkyl, (C₁-C₈)alkoxy, (C₁-C₈)alkanoyl, (C₁-C₈)alkanoyloxy, (C₁-C₈)alkanoylamino, (C₆-C₁₀)aroylamino, cyano and/or halogen.

5. A negative-working radiation-sensitive mixture as claimed in one or more of claims 1 to 4, wherein the compound a) generates acid under the action of radiation of wavelength 190 to 450 nm.

6. A negative-working radiation-sensitive mixture as claimed in one or more of claims 1 to 5, wherein the binder c) contains phenolic hydroxy groups.

7. A negative-working radiation-sensitive mixture as claimed in claim 6, wherein the binder is a substituted or unsubstituted poly(hydroxystyrene).

8. A negative-working radiation-sensitive mixture as claimed in claim 6, wherein the binder is a polymer containing a (meth)acrylic acid esterified with a compound which, in addition to the hydroxy group required for ester formation, contains free, phenolic hydroxy groups.

9. A negative-working radiation-sensitive mixture as claimed in one or more of claims 1 to 8, wherein the crosslinkable compound b) is a resol.

10. A negative-working radiation-sensitive mixture as claimed in one or more of claims 1 to 8, wherein the crosslinkable compound b) is an aromatic substituted by alkoxymethyl or oxiranylmethyl groups.

11. A negative-working radiation-sensitive mixture as claimed in one or more of claims 1 to 8, wherein the crosslinkable compound b) is a melamine/formaldehyde or urea/formaldehyde condensate.

12. A negative-working radiation-sensitive recording material, essentially composed of a support and a radiation-sensitive layer, wherein the layer contains a radiation-curable mixture as claimed in one or more of claims 1 to 11.

13. A negative-working radiation-sensitive recording material as claimed in claim 12, wherein the content of the compound a), which generates a strong acid under the action of actinic radiation, is 0.5 to 25% by weight, preferably 1 to 10% by weight, particularly preferably 2 to 7% by weight, of the total weight of the solids in the radiation-sensitive layer.

14. A negative-working radiation-sensitive recording material as claimed in claim 12, wherein the content of the compound b) having at least two groups crosslinkable by means of acid is 1 to 50% by weight, preferably 5 to 25% by weight, of the total weight of the solids in the radiation-sensitive layer.

15. A negative-working radiation-sensitive recording material as claimed in claim 12, wherein the content of the binder c), which is insoluble in water and soluble or at least swellable in aqueous solutions, is 40 to 95% by weight, preferably 50 to 90% by weight, of the total weight of the solids in the radiation-sensitive layer.

16. A negative-working radiation-sensitive recording material as claimed in claim 12, wherein the radiation-sensitive layer at a thickness of 1.0 µm has an extinction of less than 0.5, preferably less than 0.3, for radiation of 248 nm wavelength.

## Revendications

1. Mélange négatif sensible au rayonnement avec
a) un composé qui forme un acide fort sous l'effet de rayonnement actinique,
b) un composé avec au moins 2 groupes réticulables par un acide et
c) un liant polymère insoluble dans l'eau, mais soluble ou au moins gonflable en solutions aqueuses-alcalines,
caractérisé en ce que le composé a) est une 2,4,6-tris-(2-hydroxy-éthoxy)-[1,3,5]triazine estérifiée par deux ou trois acides (hétéro)arylsulfoniques.

2. Mélange négatif sensible au rayonnement selon la revendication 1, caractérisé en ce que les acides arylsulfoniques présentent 6 à 10 atomes de carbone aromatiques.

3. Mélange négatif sensible au rayonnement selon la revendication 1, caractérisé en ce que les acides hétéroarylsulfoniques présentent 4 à 9 atomes de carbone et soit un atome d'oxygène ou de soufre aromatique, soit 1 ou 2 atomes d'azote aromatique.

4. Mélange négatif sensible au rayonnement selon une ou plusieurs des revendications 1 à 3, caractérisé en ce que les acides (hétéro)-arylsulfoniques sont substitués par des groupes alkyle en C₁-C₈, alcoxy en C₁-C₈, alcanoyle en C₁-C₈, alcanoyloxy en C₁-C₈, (alcanoyle en C₁-C₈)amino, (aroyle en C₆-C₁₀)amino, cyano et/ou halogène.

5. Mélange négatif sensible au rayonnement selon une ou plusieurs des revendications 1 à 4, caractérisé en ce que le composé a) forme un acide sous l'effet de rayonnement d'une longueur d'onde de 190 à 450 nm.

6. Mélange négatif sensible au rayonnement selon une ou plusieurs des revendications 1 à 5, caractérisé en ce que le liant c) contient des groupes hydroxy phénoliques.

7. Mélange négatif sensible au rayonnement selon la revendication 6, caractérisé en ce que le liant est un poly(hydroxystyrène), éventuellement substitué.

8. Mélange négatif sensible au rayonnement selon la revendication 6, caractérisé en ce que le liant est un polymère avec un acide (méth)acrylique, lequel est estérifié avec un composé qui présente, aux côtés des groupes hydroxy libres nécessaires à la formation d'ester, des groupes hydroxy phénoliques.

9. Mélange négatif sensible au rayonnement selon une ou plusieurs des revendications 1 à 8, caractérisé en ce que le composé b) réticulable est un résol.

10. Mélange négatif sensible au rayonnement selon une ou plusieurs des revendications 1 à 8, caractérisé en ce que le composé b) réticulable est un composé aromatique substitué par des groupes alcoxyméthyle ou oxiranylméthyle.

11. Mélange négatif sensible au rayonnement selon une ou plusieurs des revendications 1 à 8, caractérisé en ce que le composé b) réticulable est un condensat de mélamine/ formaldéhyde ou d'urée/formaldéhyde.

12. Matière d'enregistrement négative sensible au rayonnement, qui est constituée essentiellement d'un support et d'une couche sensible au rayonnement, caractérisée en ce que la couche contient un mélange durcissable par irradiation selon une ou plusieurs des revendications 1 à 11.

13. Matière d'enregistrement négative sensible au rayonnement selon la revendication 12, caractérisée en ce que le composé a) formant un acide fort sous l'effet de rayonnement actinique est contenu à raison de 0,5 à 25 % en poids, de préférence de 1 à 10 % en poids, de manière particulièrement préférée de 2 à 7 % en poids par rapport au poids total de l'extrait sec de la couche sensible au rayonnement.

14. Matière d'enregistrement négative sensible au rayonnement selon la revendication 12, caractérisée en ce que le composé b) avec au moins deux groupes réticulables par un acide est contenu à raison de 1 à 50 % en poids, de préférence de 5 à 25 % en poids par rapport au poids total de l'extrait sec de la couche sensible au rayonnement.

15. Matière d'enregistrement négative sensible au rayonnement selon la revendication 12, caractérisée en ce que le liant c) insoluble dans l'eau, soluble ou au moins gonflable en solutions aqueuses, est contenu à raison de 40 à 95 % en poids, de préférence de 50 à 90 % en poids par rapport au poids total de l'extrait sec de la couche sensible au rayonnement.

16. Matière d'enregistrement négative sensible au rayonnement selon la revendication 12, caractérisée en ce que la couche sensible au rayonnement, pour une épaisseur de 1,0 µm pour un rayonnement d'une longueur d'onde de 248 nm, présente une extinction inférieure à 0,5, de préférence inférieure à 0,3.
